# EUROPÄISCHE PATENTSCHRIFT

(11) **EP 3 774 254 B1**
(45) Veröffentlichungstag und Bekanntmachung des Hinweises auf die Patenterteilung: **16.08.2023**
(21) Anmeldenummer: 19717453.5
(22) Anmeldetag: 05.04.2019
(51) Int. Cl.: B29C 33/42, B81C 1/00, B29C 33/44

(54) **VERWENDUNG EINES BAUTEILS MIT MIKROSTRUKTURIERTER OBERFLÄCHE ALS FLIESSBETT FÜR DISKRETE MENGEN EINER FLÜSSIGKEIT**
USE OF A COMPONENT HAVING A MICROSTRUCTURED SURFACE AS A FLUIDIZED BED FOR DISCRETE QUANTITIES OF A LIQUID
UTILISATION D'UNE PIÈCE POURVUE D'UNE SURFACE MICRO-STRUCTURÉE COMME LIT DE LIQUIDE POUR DES QUANTITÉS DISCRÈTES D'UN LIQUIDE

(30) Priorität: 05.04.2018 DE 102018108074
(43) Veröffentlichungstag der Anmeldung: 17.02.2021
(73) Patentinhaber: Fraunhofer-Gesellschaft zur Förderung der angewandten Forschung e.V., 80686 München (DE)
(72) Erfinder: VISSING, Klaus-Dieter, 28359 Bremen (DE); SCHMIDT, Stefanie, 28832 Achim (DE)
(74) Vertreter: Eisenführ Speiser
(86) Internationale Anmeldenummer: PCT/EP2019/058695
(87) Internationale Veröffentlichungsnummer: WO 2019/193177

(56) Entgegenhaltungen:
- WO-A1-2015/074077
- WO-A1-2017/037918
- DE-A1- 10 138 036
- US-A1- 2017 095 019

## Beschreibung

Die vorliegende Erfindung betrifft die Verwendung eines Bauteils mit wenigstens teilweise gekrümmter Oberfläche mit einer Mikrostrukturierung aus Strukturierungselementen wenigstens im Bereich der Krümmung, wobei die Strukturierungselemente eine ganz bestimmte Ausgestaltung haben und auf eine bestimmte Weise zueinander ausgerichtet sind, als Fließbett für distinkte Mengen einer Flüssigkeit. Insbesondere betrifft die vorliegende Erfindung die Verwendung des entsprechenden Bauteils in einem Wasserspielzeug oder einem Anschauungsobjekt.

### Stand der Technik

Spätestens seit superhydrophobe Oberflächeneigenschaften, durch den Lotus Effekt bekannt und sichtbar geworden sind, zur Verfügung stehen, haben Menschen mit derartigen Oberflächen gespielt und deren Verhalten ausprobiert. Schnell kommt man zu der Idee ein Spielzeug zu gestalten. So existiert z.B. eine Offenlegungsschrift mit dem Namen "Wasserkugelbahn" (DE102007022229A1). Dort wird eine Kugelbahn mit einer hydrophoben Innenfläche beschrieben. Die Lauffläche ist eine halbkreisförmige Rinne. Jedoch fehlt eine genauere technische Beschreibung mit Angaben von Wasserrandwinkeln zur Definition des Begriffes "hydrophob". Ebenso fehlt der Begriff "superhydrophob" als auch der Zusammenhang des Effektes mit einer Oberflächenstruktur. Genauer wird da US 4 199 142 "Toys and games using super-hydrophobic surfaces". Dieses Dokument beschreibt im Grundsatz Wasserspielzeuge mit superhydrophober Oberfläche. Die superhydrophobe Oberfläche wird, ebenso wie in US 4 142 724 durch die Applikation von hydrophobierten Silikondioxydpartikeln erreicht, welche über ein hydrophobes Bindersystem zu einer Schicht zusammengelagert werden. Eine solche Schicht wird zwangsläufig porös sein, was dazu führt, dass Stoffe, insbesondere Fette etc. in die Beschichtung eindringen können und so sowohl die Oberflächeneigenschaften, als auch die Schichthaftung zum Untergrund negativ beeinflussen. Ferner kann nicht ausgeschlossen werden, dass durch mechanische Belastung einzelne Partikel aus der Schicht herausgelöst werden. Insofern ist eine Verwendung für ein (Kinder-) Spielzeug auszuschließen. Ferner erlaubt die Vorgehensweise nicht die Herstellung geordneter Strukturen. Damit kann nicht ausgeschlossen werden, dass an einzelnen Stellen der Bauteiloberfläche keine superhydrohoben Eigenschaften mehr vorliegen.

Hydrophobe plasmapolymere Schichten sind bekannt und in vielfältiger Form von der Fraunhofer Gesellschaft patentiert worden (z.B. DE 102006018491 A1). Diese sind in der Lage bereits ab Schichtdicken von ca. 10-20 nm geschlossene Filme zu bilden. Deshalb sind sie besonders geeignet Texturen und Strukturen, auch Nanostrukturen, exakt abzubilden. Sie zeichnen sich durch eine hohe chemische Stabilität aus und können hohe E-Module aufweisen, so dass sie ggf. härter sind als das Substratmaterial. Die Verwendung für ein Spielzeug ist neu.

Gegenstände mit speziellen Oberflächeneigenschaften sind auch in der WO 2015/074077 A1 und der US 2017/095019 A1 offenbart.

Zusätzlich zu plasmapolymeren Schichten können (super-) hydrophobe Oberflächen beispielweise auch mit Anti-Wetting Sprays oder Lacken erzeugt werden. Beispiele hierfür sind:
- NeverWet^{®} (http://www.neverwet.com/) Eine Familie von superhydrophoben Beschichtungen, sowohl für industrielle als auch Endanwender, welche Wasser und dicke Öle abweist.
- Ultra-Ever Dry^{®} (http://www.spillcontainment.com/products/ever-dry) 2-Komponenten-System aus Bottom und Top Coat, welche nur zusammen zum superhydrophoben Effekt führen. Anwendung von eigener omniphober (sowohl hydrophob als auch lipophob) Technologie, um eine Oberflächenchemie und - textur mit geometrischen Formen, die Peaks bzw. hohe Punkte haben, zu erzeugen. An den erhöhten Punkten werden Wasser, einige Öle, Frischbeton sowie andere Flüssigkeiten abgestoßen.
- DryWired^{™} Super Hydrophobic Coating (SHC) (https://drywired.com/product/superhydrophobic-coating/) Flüssige Lösung, welche mit Pinsel oder per Walze/Roller als superhydrophober Film aufgetragen werden kann.

Es existiert zudem eine Offenlegungsschrift mit dem Namen "Manufacture method for super-hydrophobic plastic" (CN000105254997A). Zum Kunststoff-Granulat werden unter anderem Siliziumdioxid-Partikel in drei verschiedenen Größen zugegeben, welche eine unregelmäßige Oberflächenstruktur im Endprodukt erzeugen werden.

Vor dem Hintergrund des Standes der Technik war es Aufgabe der vorliegenden Erfindung, einen Ansatz bereitzustellen, mit dem diskrete Mengen von Flüssigkeit für Spiel- und Anschauungszwecke auf Oberflächen bewegt werden können. Bevorzugt sollte die Anwendung dabei so ausgestaltet sein, dass kein Risiko besteht, dass aus den einzusetzenden Oberflächen Partikel austreten und/oder die einzusetzenden Oberflächen sollten in einem sicheren und günstigen Produktionsverfahren herstellbar sein und/oder die gewünschten Oberflächeneigenschaften, insbesondere eine Superhydrophobizität oder Superhydrophilie sollten sicher erreichbar sein.

Dabei sollte bei der bevorzugten Anwendung gewährleistet sein, dass die entsprechenden Flächeneigenschaften auch dann wirken, wenn die Oberfläche einfach oder sogar mehrfach gekrümmt ist und/oder wenn z.B. auf Grund von Fliehkräften Kräfte auf die Oberfläche wirken, die nicht senkrecht zur Erdoberfläche gerichtet sind.

Diese Aufgabe wird gelöst durch eine Verwendung eines Bauteils mit wenigstens teilweise gekrümmter Oberfläche (9) mit einer Mikrostrukturierung aus Strukturierungselementen (7) wenigstens im Bereich der Krümmung (9), wobei der Gegenstand eine Entnahmerichtung (15) besitzt, die sich im Fall von parallel zueinander ausgerichteten Seitenflächen der Mikrostrukturierungselemente (11 und 13) durch die zu diesen Seitenelementen parallele Richtung definiert und sofern die Seitenelemente (11 und 13) der Mikrostrukturierungselemente nicht parallel zueinander ausgerichtet sind, durch diejenige Richtung bestimmt, mit der es mit geringstem Kraftaufwand möglich ist, den Gegenstand mit Mikrostrukturierung aus einer Form zu entnehmen, in der dieser Gegenstand geformt wurde,
wobei
(i) die Strukturierungselemente (7) unabhängig von der Krümmung parallel zu einander ausgerichtet sind,
(ii) die Strukturierungselemente jeweils eine von der Oberfläche des Gegenstandes (1) weg gerichtete zu den anderen Mikrostrukturierungselementen gleichgroße Fläche (5) besitzen und
(iii) die jeweilige Entfernung (3) zwischen den jeweils benachbarten (bevorzugt parallel ausgerichteten) Seitenflächen (11, 13) der Strukturierungselemente (7) gleich ist,
   - wenn diese Strukturierungselemente (7) gemeinsam auf einer der Ebenen liegen, in der auch die Entnahmerichtung (15) liegt, und
   - die Entfernung (3) auf einer Geraden gemessen wird, die jeweils parallel zur Tangente (8) verläuft, die an dem Streckenmittelpunkt (6) zwischen den jeweiligen Strukturierungselementen (7) anliegt und wobei die Tangente (8) und
   - die dazu parallele laufende Gerade, auf der gemessen wird, so gelegt werden, dass die kürzest mögliche Strecke (3) entsteht, die beide benachbarte Strukturierungselemente berührt und
   - im von der Oberfläche des Gegenstandes (1) entferntesten Punkt wenigstens einer der Seitenflächen (11) und (13) endet,

   als Fließbett für diskrete Mengen einer Flüssigkeit bevorzugt einer Flüssigkeit mit einer Oberflächenspannung ≥ 60 mN/m, bevorzugt ≥ 68 mN/m wobei die diskreten Mengen der Flüssigkeit sich auf der Mikrostrukturierung fortbewegen.
   als Fließbett für diskrete Mengen einer Flüssigkeit bevorzugt einer Flüssigkeit mit einer Oberflächenspannung ≥ 60 mN/m, bevorzugt ≥ 68 mN/m , wobei die diskreten Mengen der Flüssigkeit sich auf der Mikrostrukturierung fortbewegen.

Die Erläuterung der erfindungsgemäßen Lösung lässt sich sehr gut anhand der Fig. 1 bis 3 durchführen. Dabei ist die
- Fig. 1: die schematische Darstellung einer erfindungsgemäßen Lösung,
- Fig. 2: eine weitere schematische Darstellung der erfindungsgemäßen Lösung und die
- Fig. 3: ebenfalls eine alternative schematische Darstellung der erfindungsgemäßen Lösung.

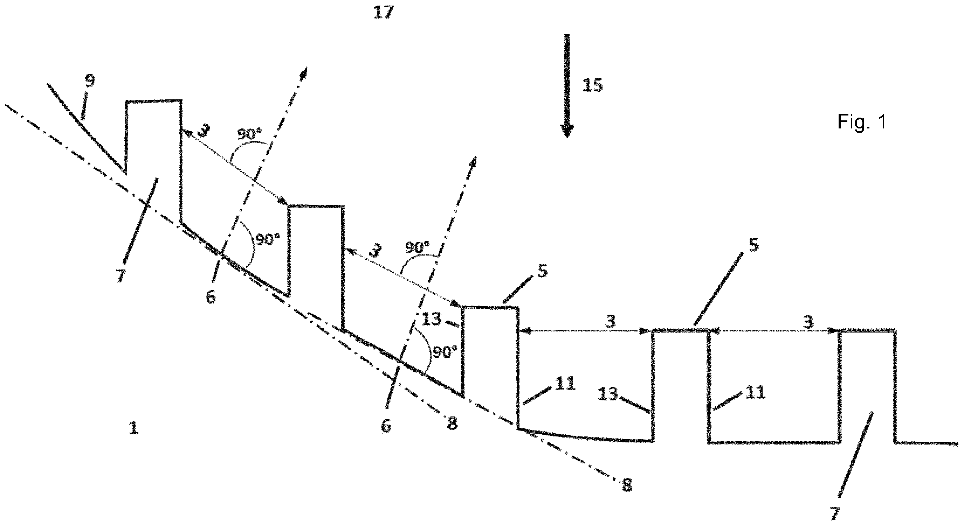

Die Bezugszeichen bedeuten für alle Fig. 1 bis 3 dabei Folgendes:
- 1: Gegenstand
- 3: Entfernung zwischen den jeweils benachbarten, bevorzugt parallel ausgerichteten Seitenflächen
- 5: vom Gegenstand weg gerichtete Fläche
- 6: Streckenmittelpunkt zwischen zwei Strukturierungselementen
- 7: Strukturierungselemente
- 8: Tangente anliegend am Streckenmittelpunkt 6
- 9: Krümmung der Oberfläche
- 11, 13: Seitenflächen der Strukturierungselemente
- 15: Entnahmerichtung
- 17: Form

Die Strukturierungselemente im Sinne dieser Erfindung sind Erhebungen aus der Oberfläche 9 des Gegenstandes 1 in einer Größenordnung einer Höhe von 100 nm bis 1 mm, bevorzugt 1 µm bis 0,5 mm, weiter bevorzugt 10 µm bis 250 µm.

Die Strukturierungselemente bilden gemeinsam die Mikrostrukturierung.

Sofern von der gekrümmten Oberfläche oder der Oberfläche des Gegenstandes gesprochen wird, ist damit insbesondere der Bereich zwischen den Mikrostrukturierungselementen zu verstehen. Es ist selbstverständlich, dass auch die Mikrostrukturierungselemente Teil der Oberfläche des Gegenstandes sind; sofern aber im Rahmen dieser Anmeldung nicht explizit darauf hingewiesen wird, ist mit der Oberfläche des Gegenstandes der Verlauf der Oberfläche gemeint, der ohne die Mikrostrukturierungselemente vorliegen würde.

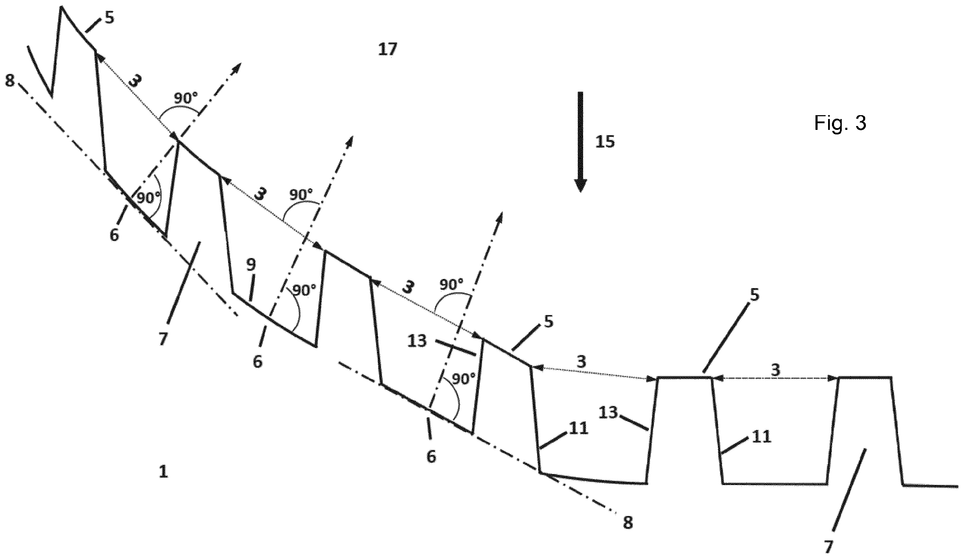

Die Entnahmerichtung 15 definiert sich im Falle von parallel zueinander ausgerichteten Seitenflächen (der Mikrostrukturierungselemente) 11 und 13 durch in die zu diesen Seitenelementen parallele Richtung. Sofern die Seitenelemente 11 und 13 nicht parallel zueinander ausgerichtet sind, wie es z. B. in der Fig. 3 der Fall ist, bestimmt sich die Entnahmerichtung 15 durch diejenige Richtung, die es mit dem geringsten Kraftaufwand ermöglicht, den Gegenstand mit Mikrostrukturierung aus einer Form zu entnehmen, in der dieser Gegenstand geformt wurde.

Im Sinne der vorliegenden Anmeldung sind Strukturierungselemente parallel zueinander ausgerichtet, wenn die jeweiligen Seiten 13 zueinander parallel sind bzw. die jeweiligen Seiten 11 der einzelnen Strukturierungselemente 7. Die Entfernung 3 zwischen den einzelnen Strukturierungselementen 7 ist jeweils gleich, sofern die Strukturierungselemente 7 in einer Ebene liegen, in der auch die Entnahmerichtung liegt. Dabei verläuft die Strecke 3 parallel zur Tangente 8, die auf dem Streckenmittelpunkt 6 zwischen den jeweiligen Strukturierungselementen 7 anliegt. Der Streckenmittelpunkt definiert sich dabei als der Mittelpunkt der kürzesten Strecke zwischen zwei Strukturierungselementen, wobei faktisch an der engsten Stelle eines Tals zwischen zwei Strukturierungselementen gemessen wird.

Wie aus den Fig. 1, 2 und 3 hervorgeht, ist es möglich, die Strukturierungselemente 7 in unterschiedlicher Weise auszugestalten. Bedeutsam im Sinne dieser Erfindung ist die Parallelität der Strukturierungselemente gegenüber der Entnahmerichtung. So ist es möglich, mit einem möglichst geringen Widerstand und insbesondere ohne Hinterschneidungen den Gegenstand nach seiner Formgebung aus der Form zu entnehmen, ohne dass die Mikrostrukturierung mechanisch über die Maße beansprucht wird. Durch die spezielle Ausgestaltung der Flächen 5 und die Entfernung der Mikrostrukturierungselemente zueinander ist es möglich, einem Flüssigkeitstropfen, bezogen auf die Senkrechte über der Oberfläche des Gegenstandes 1 eine sehr ähnliche bis weitgehend identische Mikrostrukturierungsfläche zur Verfügung zu stellen, auf der er zu liegen kommt. Dies hat positive Folgen für den sich ausbildenden Wasserrandwinkel. Eine erfindungsgemäße bevorzugte Variante ist ein Gegenstand, wobei die Strukturierungselemente 7 einen runden, quadratischen, ovalen oder rechteckigen Querschnitt gleicher Fläche über wenigstens die Hälfte ihrer Höhe verfügen.

Solche Strukturierungselemente sind gut handhabbar, verhältnismäßig stabil, und es bestehen Techniken, sie zu erzeugen.

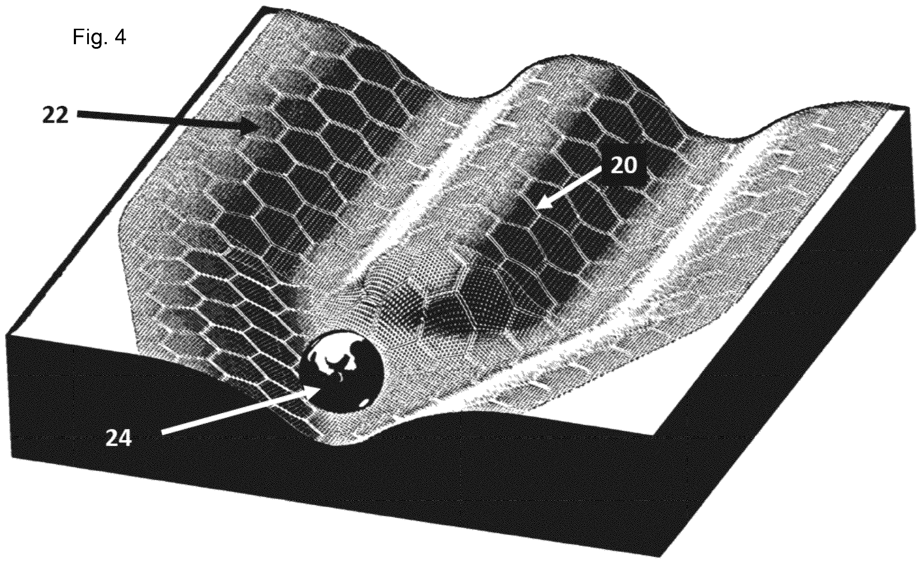

Ein Fließbett im Sinne der vorliegenden Erfindung ist eine räumliche Ausgestaltung, die auf Grund ihrer Topografie dazu führt, dass Flüssigkeiten sich bevorzugt innerhalb dieses Bereiches befinden und sich zusätzlich darin fortbewegen, bevorzugt durch die Wirkung der Erdanziehung. Dies bedeutet, dass ein Fließbett sich bevorzugt durch ein Gefälle auszeichnet, durch das in dem Fließbett vorhandene Flüssigkeiten zur Fortbewegung in eine bestimmte Richtung veranlasst werden. Weiter bevorzugt sind Fließbetten in ihrer umgebenden Topografie in Richtung Erdoberfläche abgesenkt. Dies ist aber keine zwingende Voraussetzung, wird aber für eine Definition im Zweifelsfall bevorzugt sein. Grundsätzlich umfasst ein Fließbett (im Bereich der nicht bevorzugten Definition von "Fließbett") jeden Bereich auf dem sich eine Flüssigkeit, insbesondere ein Flüssigkeitstropfen fortbewegt und darin geführt wird. Im Sinne dieser weiteren Definition kann ein Fließbett auch ein Looping sein, wenn es so ausgestaltet ist, dass bei entsprechender Eingangsgeschwindigkeit eine Flüssigkeit auf Grund Ihrer geschwindigkeitsbedingten Fliehkraft auch Bewegungen vollführt, die von der Erdanziehungskraft weggerichtet sind. Ein Beispiel für ein Fließbett ist in der Figur 4 dargestellt.

Die Figur 4 stellt die schematische Darstellung des Bauteils für die erfindungsgemäße Verwendung dar. Dabei bedeuten:
20 Fließbett
22 Erhöhung zwischen zwei Fließbetten
24 Flüssigkeitstropfen

Man kann sehen, dass es in der Figur 4 bevorzugte Bereiche gibt, in denen sich ein Flüssigkeitstropfen fortbewegt.

Eine diskrete Menge einer Flüssigkeit im Sinne der vorliegenden Erfindung ist eine Menge Flüssigkeit, die sich von einer großen, nicht Einzel unterscheidbaren Menge abhebt. Bevorzugt weist eine diskrete Menge der Flüssigkeit ein Volumen von ≤ 10 ml, bevorzugt ≤ 1 ml und weiter bevorzugt ≤ 0,5 ml auf. Weiter bevorzugt ist eine diskrete Menge einer Flüssigkeit im Sinne der vorliegenden Erfindung dasjenige Volumen, das mittels einer geeigneten Tropfvorrichtung erzeugt wird. Dabei ist es sehr wohl möglich, dass einzelne Tropfen auch einen fortlaufenden Flüssigkeitsstrom erzeugen.

Erfindungsgemäß bevorzugt ist die Verwendung des Gegenstandes, wobei die von der Oberfläche des Gegenstandes weg gerichteten Flächen der Strukturierungselemente parallel zueinander ausgerichtet sind.

Diese Situation ist in der Fig. 1 dargestellt. Der Vorteil an dieser Form von Strukturierungselementen besteht darin, dass sie technisch leicht zu erzeugen sind bzw. dass eine Form für sie technisch leicht zu erzeugen ist.

Eine noch weiter bevorzugte Alternative ist die Verwendung des Gegenstandes, wobei die der Oberfläche des Gegenstandes weg gerichteten Flächen der Strukturierungselemente parallel zu der gekrümmten Oberfläche des Bauteils ausgerichtet sind.

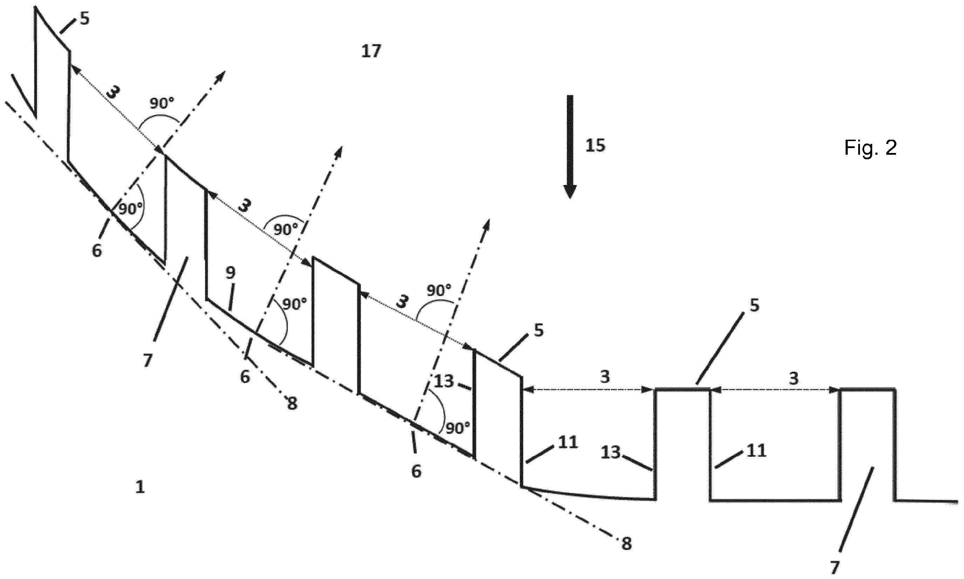

Diese Variante ist in den Fig. 2 und 3 verwirklicht. Dies hat den Vorteil, dass senkrecht über der Oberfläche für einen Flüssigkeitstropfen die gleiche Auflagefläche an jeder Stelle der Krümmung vorhanden ist.

Wie bereits oben angedeutet, ist es im Sinne der Erfindung notwendig, dass die Strukturierungselemente 7 so ausgerichtet sind, dass im Sinne der Entnahmerichtung 15 Hinterschneidungen vermieden werden. Nur so ist eine zerstörungsfreie Entformung aus der Form beim Formen des Gegenstandes möglich.

Bevorzugt im Sinne der Erfindung ist, dass die Seiten der Strukturierungselemente 7 in Richtung der Entformungsrichtung parallel mit maximaler Auslenkung von 1 bis 3°, bevorzugt vollständig parallel ausgestaltet sind.

Dabei ist es bevorzugt, dass die Mikrostrukturierungselemente selber als Grundform eine Quaderform, eine Würfelform, eine Prismenform (mit abgeschnittener Spitze), eine Zylinderform oder die Form einer abgestumpften Pyramide oder eines abgestuften Kegels, als auch die Form eines doppelt abgestumpften Ellipsoiden besitzen. Insbesondere sind Strukturierungselemente in Walzen- oder Kegelform bevorzugt. Dabei wird der Fachmann anhand des oben Beschriebenen verstehen, dass die jeweils beschriebenen Formen nur gelten, soweit sie nicht die "Verankerung" des Mikrostrukturierungselementes in der Oberfläche des Gegenstandes betreffen und in einigen Ausgestaltungen auch soweit sie nicht die Fläche 5 im oberen Bereich der Strukturierungselemente betreffen.

Die Anordnung der Strukturierungselemente im erfindungsgemäß zu verwendenden Gegenstand ermöglicht nicht nur eine gute Entnahme aus der Form, sondern stellt gleichzeitig sicher, dass aus der Betrachtungsweise senkrecht zur Oberfläche 9 des Gegenstandes weitgehend die gleiche Auflagefläche für Flüssigkeitstropfen zur Verfügung steht.

Die erfindungsgemäß zu verwendenden Gegenstände umfassen wenigstens eine gekrümmte Fläche, wobei diese Fläche in wenigstens einer Raumrichtung, bevorzugt aber in wenigstens zwei Raumrichtungen gekrümmt ist.

Aufgrund der Anordnung der Strukturierungselemente ist es erfindungsgemäß bevorzugt, dass die Steigung der Krümmung in jede Raumrichtung bezogen auf die Entnahmerichtung 15 ≤ 70° ist, bevorzugt ≤ 65° und weiter bevorzugt ≤ 60°. Dabei ist es nicht erforderlich für den erfindungsgemäß zu verwendenden Gegenstand, dass sämtliche Krümmungen in Raumrichtung diese Werte unterschreiten. Es ist jedoch bevorzugt, dass in wenigstens einer Krümmung eine entsprechende Wertunterschreitung vorliegt.

Bevorzugt ist eine erfindungsgemäße Verwendung eines Gegenstandes, wobei die Strukturierungselemente 7 aus dem gleichen Material bestehen wie die darunterliegende Oberfläche des Gegenstandes, bevorzugt wie der gesamte Gegenstand.

Ein solcher Gegenstand ist über eine Vielzahl von Formgebungsverfahren zugänglich, wobei die Mikrostrukturierung aus dem zu formenden Material gebildet wird.

Bevorzugt ist die Verwendung eines Gegenstandes, wo im Bereich der Mikrostrukturierung zusätzlich Makrostrukturen vorgesehen sind zum mechanischen Schutz der Mikrostrukturierung.

Eine Makrostruktur im Sinne dieser vorliegenden Erfindung ist bevorzugt netzartig angeordnet mit Netzlöchern, deren Zellbegrenzungen einen maximalen Abstand von 500 µm bis 100 mm, bevorzugt 1 mm bis 25 mm, weiter bevorzugt 3 mm bis 10 mm aufweisen.

Bevorzugte Zellgeometrien sind Dreiecke, Vierecke, Fünfecke und Sechsecke. Es können ebenfalls Zellen mit einer L-Geometrie, einer T-Geometrie, Doppel-T-Geometrie, S-Geometrie oder verschränkten T-Geometrie (analog Verbund-Pflastersteinen) Verwendung finden. Diese Geometrien können auch kombiniert werden, um schließlich das Netz aufzubauen.

Die Stegbreite dieser Netzstruktur ist, um den Effekt der Mikrostrukturierung nicht zu stark zu stören, besonders klein zu halten, so dass der Traganteil der Makrostruktur möglichst klein ist. Die Stegbreiten sind zwischen 50 µm und 2 mm, bevorzugt 200µm und 500µm zu wählen.

Die Netzstruktur weist Strukturhöhen im Bereich 50 µm bis 100 mm, bevorzugt 100µm bis 3 mm, bevorzugt 200 µm bis 1 mm auf.

Durch die Makrostruktur kann die Mikrostruktur bei schabender Beanspruchung effektiv vor Beschädigung geschützt werden. Bei der Auswahl der Größe der Netzlöcher berücksichtigt man bereits bei Auslegung die Größe der Struktur, die eine mechanische Beanspruchung im späteren Gebrauch des Artikels auslösen kann.

Auch bei den Makrostrukturen weisen die einzelnen Stege bevorzugt Ausformschrägen auf, die das sichere Ausformen ermöglichen, bevorzugt zwischen 0,01 ° und 5°, weiter bevorzugt 0,1° und 2°, besonders bevorzugt 0,5 und 1°.

Sofern Makrostrukturen im Bereich der erfindungsgemäß vorzusehenden Mikrostrukturierung vorhanden sind, ist es selbstverständlich, dass die Entfernungen zwischen den benachbarten Strukturierungselementen, wie sie Merkmal der vorliegenden Erfindung sind, nur für die Bereiche gelten, wo gleichartige Elemente, die Teil der Mikrostrukturierung sind, nebeneinanderliegen. Mit anderen Worten, Makrostrukturen, die zwischen Strukturierungselementen der Mikrostrukturierung liegen, sorgen dafür, dass die Entfernungsvorgaben zwischen den (durch die Makrostruktur unterbrochenen) Mikrostrukturierungsbereichen nicht gelten.

Weiter erfindungsgemäß bevorzugt ist die Verwendung eines Gegenstandes, wobei der Gegenstand im Bereich der Mikrostrukturierung über einen statischen Wasserrandwinkel gemessen nach DIN 55660 von ≥ 130°, bevorzugt ≥ 150° verfügt. Dabei ist es selbstverständlich, dass die Messung des Wasserrandwinkels im Sinne der vorliegenden Erfindung stets senkrecht über der Oberfläche des erfindungsgemäßen Gegenstandes vorgenommen wird.

Es ist also möglich, mit der erfindungsgemäß einzusetzenden Mikrostrukturierung Situationen zu schaffen, bei denen der Wasserrandwinkel auch bei gekrümmten Oberflächen bei einer Messung senkrecht zur Oberfläche stets annähernd gleich ist oder sogar vollständig gleich ist. Dies ist insbesondere für dynamische Anwendungen wie z. B. in Rohren oder Rinnen interessant, bei denen Flüssigkeiten mit einer hohen Geschwindigkeit geführt werden, sodass diese in Kurven entlang dem Kurvenverlauf durch eine durch die Krümmung bewirkte Fliehkraft an die Oberfläche des Gegenstandes gepresst werden.

In der erfindungsgemäßen Verwendung ist es möglich, die Strukturierungselemente so anzuordnen, dass sie dem generellen Verlauf der Oberfläche des Gegenstandes ortslokal angepasst sind. Damit ist es möglich, bezogen auf die Senkrechte über gekrümmten Oberflächen besonders gleichmäßige Auflagebedingungen für Flüssigkeiten zu erzeugen.

Die Formen für die erfindungsgemäß zu verwendenden Gegenstände für ihr Herstellungsverfahren sind über verschiedene Herstellungsverfahren zugänglich. Der Fachmann ist dabei in der Lage, mit den geeigneten Mitteln entsprechende Formen herzustellen.

Eine Variante hierzu ist die Lasermikrostrukturierung: Gepulste Laser werden bevorzugt für die Erzeugung von mikrostrukturierten Formen, aber auch von mikrostrukturierten Oberflächen im Sinne der vorliegenden Erfindung eingesetzt. Durch den gezielten Materialabtrag sind Laserstrukturierungen sehr präzise und beeinflussen die Eigenschaften des umliegenden Materials nicht. Mikrobearbeitungen durch Laserbearbeitung weisen ein hohes technisches und ökonomisches Potential auf. Die Einsatzbereiche sind vielfältig. In diesem Mikrostrukturierungsverfahren ist es möglich, Mikrostrukturierungen sowohl als positiv (im Sinne des erfindungsgemäßen Gegenstandes) oder als negativ (im Sinne der erfindungsgemäßen Form) herzustellen. Dabei ist es bevorzugt, die Lasermikrostrukturierung für die Form einzusetzen.

Durch den Einsatz von Ultrakurzpuls-Lasern kann eine schmelzearme und gratfreie Strukturierung mit hoher Präzision in nahezu allen Materialien erzeugt werden, sodass noch nicht einmal eine Nachbearbeitung nötig ist. Abhängig vom Material und den herzustellenden Stückzahlen erfolgt die Laserbehandlung entweder direkt auf dem Bauteil oder replikativ während eines Ur- oder Umformungsprozesses wie dem Spritzguss.

Ein alternatives Verfahren zur Herstellung der erfindungsgemäß einzusetzenden Mikrostrukturen ist das SLM-Verfahren. Beim Lasersintern von metallischen Pulvern (Selective Laser Melting - SLM) wird die Bauteilkonstruktion in Bauebenen zerlegt und anschließend diese Information Schicht für Schicht von einem Laser in ein Pulverbett geschrieben. Dabei schmilzt die durch den Laser eingebrachte Energie ein Metallpulver in einem sehr schmalen Bereich auf, wodurch sich letztendlich metallische Bauteile unterschiedlicher Größe mit sehr hoher geometrischer Freiheit herstellen lassen. Die SLM-Technologie gehört zu den additiven Fertigungsverfahren, die eine Bauteilherstellung direkt aus einem Datensatz heraus erlauben. Durch die gezielte Parametereinstellung und Pulverauswahl lässt sich die Oberflächenstruktur variieren und funktionalisieren. Ebenso ermöglicht der hohe konstruktive Freiheitsgrad des SLM-Verfahrens eine weitere Funktionsintegration durch das Einbringen innerer Strukturen, z. B. Reaktionskanäle in das Bauteil.

Bevorzugt ist eine erfindungsgemäße Verwendung, wobei die Flüssigkeit zu ≥ 70 Volumen-%, bevorzugt ≥ 85 Volumen-% aus Wasser besteht.

Da es bei der erfindungsgemäßen Verwendung möglich ist, Oberflächen mit hoher Hydrophobizität, bevorzugt mit Superhydrophobizität also einer Hydrophobizität mit einem Wasserrandwinkel von ≥ 130° bevorzugt ≥ 150° bereitzustellen, ist Wasser eine besonders geeignete Flüssigkeit für die erfindungsgemäße Verwendung. Wasser ist preisgünstig, aus gesundheitlichen Gesichtspunkten unbedenklich und steht in jedem Haushalt zur Verfügung.

Bevorzugt ist eine erfindungsgemäße Verwendung wobei ein Mittel zur Verbesserung der optischen Wahrnehmbarkeit den diskreten Mengen der Flüssigkeit beigesetzt wird. Ein solches Mittel zur Verbesserung der optischen Wahrnehmbarkeit kann zum Beispiel eine Farbe sein, die in Kombination mit der Farbe des Bauteils die Kontraste erhöht. Es ist natürlich auch möglich die Farbe des Bauteils so zu wählen, dass Wasser besonders auffällt, zum Beispiel indem man satte Farben, insbesondere dunkle Farben einsetzt.

Im Rahmen der Erfindung ist es auch möglich, die Flüssigkeit mit Konverterpartikeln zu versetzen, welche UV-Licht in sichtbares Licht umwandeln. Dadurch ist es möglich, die diskrete Menge an Flüssigkeit selbstleuchtend zu gestalten, um insbesondere in der Dunkelheit entsprechende Effekte zu erzielen.

Ebenso ist es möglich, Mittel einzusetzen, die Phosphoreszenz aufweisen sowie Strahlungsquellen, die in Kombination (oder auch ohne Kombination) mit dem Mittel in der Flüssigkeit die optische Wahrnehmbarkeit der diskreten Mengen an Flüssigkeit, bevorzugt in Form eines Tropfens oder einer Kugelform, verbessern.

Bevorzugt ist eine erfindungsgemäße Verwendung, wobei das Bauteil Teil eines Stecksystems ist.

Dabei ist es erfindungsgemäß bevorzugt, dass das Stecksystem eine Vielzahl von erfindungsgemäß zu verwendenden Bauteilen umfasst, sodass sich fortgesetzte und miteinander kombinierte Fließbetten ergeben können. Gleichzeitig bietet ein Stecksystem den weiteren Vorteil, dass bei entsprechender Ausgestaltung der erfindungsgemäß zu verwendenden Bauteile eine Vielzahl von Fließbettstrukturen erstellt werden können. Ein Beispiel für ein geeignetes Stecksystem ist US3005282A.

Bevorzugt ist eine erfindungsgemäße Verwendung in einem Wasserspielzeug oder einem Anschauungsobjekt.

Ein Wasserspielzeug in der vorliegenden Erfindung ist ein zur Erbauung vorgesehener Gegenstand, in dem Wassertropfen oder andere Flüssigkeitstropfen für optische Effekte eingesetzt werden.

Ein Anschauungsobjekt im Sinne der vorliegenden Erfindung kann selbstverständlich auch ein Wasserspielzeug sein, dient aber bevorzugt dazu, bestimmte Vorgänge wie zum Beispiel physikalische Vorgänge zu veranschaulichen.

Bevorzugt ist eine erfindungsgemäße Verwendung, wobei das Wasserspielzeug oder das Anschauungsobjekt ausgewählt sind aus der Gruppe bestehend aus Wasserkugelbahn, Geschicklichkeitsspiel, Suchspiel, Wettbewerbsspiel, Lernspiel, Geduldspiel, Steckspiel, Flipper, Labyrinth, Anordnung für physikalische oder technische Experimente, Nachbildung technischer Einrichtungen und Nachbildung von biologischen Elementen.

Insbesondere bevorzugt ist eine erfindungsgemäße Verwendung, wobei das Wasserspielzeug oder das Anschauungsobjekt eine Vorrichtung für das Fließbett der Flüssigkeit enthält, ausgewählt aus der Gruppe bestehend aus Sprungschanze, Looping, Kurve, Steilkurve, Weiche, Tropfenteiler, Tropfenkollisionszone, Tropfentransportmechanismus, Tropfenkreisel, Trichter und Behälter.

Die erfindungsgemäße Verwendung ermöglicht es also insbesondere ein bevorzugt superhydrophobes (Kinder-) Spielzeug bereit zu stellen, im Speziellen eine Kugelbahn. Dabei ist das Spielzeug so gestaltet, dass statt Festkörperkugeln aus Metall, Kunststoff, Glas oder Holz jetzt Wasserkugeln die Bahn herunterrollen. Bevorzugt soll der Wassertropfen dabei eine weitgehend perfekte Kugel bilden, so dass ein Rollvorgang sichergestellt wird. Somit ist eine wasserführende Oberfläche mit superhydrophober Ausstattung (Wasserrandwinkel ≥ 130° bevorzugt ≥ 150°) bevorzugt. Die wasserführenden Oberflächen werden dreidimensional gestaltet, beispielsweise in Form einer Rinne. Wenn eine superhydrophobe Oberfläche in Form einer Kugelbahn bereitgestellt wird, so ist der Rollvorgang außerordentlich rasant, da nur sehr geringe Neigungswinkel benötigt werden. Es sind Sprungschanzen, Loopings, überhöhte Kurven, Weichen und vielerlei mehr Elemente verwirklichbar. Zudem werden bevorzugt neben den eigentlichen Bahnelementen zusätzliche Elemente eingesetzt, insbesondere wie oben beschrieben. Derart könnten beispielsweise reale Achterbahnen oder Bobbahnen oder Wasserrutschen nachgebildet werden.

Ferner ist eine erfindungsgemäße Verwendung bevorzugt wobei das Wasserspielzeug oder das Anschauungsobjekt eines oder mehrere weitere Funktionselemente umfasst, ausgewählt aus der Gruppe bestehend aus Tropfenzähler, Tropfenerzeuger, Tropfenbeschleuniger, Flüssigkeitshebevorrichtung, Geschwindigkeitsmessvorrichtung, Kippvorrichtung, Weichenbetätigungsvorrichtung und Fließbettsperrvorrichtung.

Bevorzugt wird die Kugelbahn aus Bausteinen ähnlich denen zu Lego oder Duplo zusammengesetzt. Demzufolge werden die einzelnen Bauteile bevorzugt als Spritzgussbauteil hergestellt. Dabei wird der geneigte Fachmann darauf achten, dass im strukturierten Bereich keine scharfen Kanten vorhanden sind. Bevorzugt werden die Radien so gestaltet, dass sie größer sind als die Tropfen, welche für das Spiel maximal (z.B. 100 µl) zur Verwendung kommen sollen.

Zur Erhöhung der Hydrophobizität des mikrostrukturierten Bereiches des erfindungsgemäß verwendenden Bauteiles wird es in vielen Fällen bevorzugt sein, die Mikrostrukturierung mit einer niederenergetischen, konturnachbildenden Beschichtung zu versehen. Bevorzugt ist hierfür eine plasmapolymere Beschichtung, ganz besonders bevorzugt eine solche, wie sie in der DE102013219337B3 oder in der EP02012938B1 offenbart ist.

Jedoch sind grundsätzlich auch andere Beschichtungen, wie Sol-Gel Beschichtungen oder auch Lacke denkbar. Ausschlaggebend ist, dass sie auf ebenen, nicht strukturierten Oberflächen einen Wasserrandwinkel von > 90° ermöglichen und die Oberflächenstruktur des Bauteils abbilden können, chemisch inert sind, so dass sie für Kinderspielzeug eingesetzt werden können. Die Beschichtung ist bevorzugt im strukturierten Bereich des Bauteils geschlossen, verfügt über eine sehr gute Adhäsion zum Substrat als auch über eine hohe innere Festigkeit (Kohäsion). Ferner sollte die Beschichtung auf der strukturierten Oberfläche gereinigt werden können, falls sie z.B. durch fettige Substanzen, Staub, etc. verschmutzt wird. Bevorzugt wird die Beschichtung über ein E-Modul verfügen, welches gleich groß oder geringfügig größer ist, als das des Grundkörpers, insbesondere eines spritzgegossenen Grundkörpers.

Neben der Kugelbahn sind weitere Spielzeuge mit Wasserkugeln denkbar, so z.B. ein Geschicklichkeitsspiel für Innen und Außen - auch als Wettbewerbsspiel (Bsp. Balancierspiel, Fangspiel, Tropfen entlang einer "Rennstrecke" blasen), Suchspiel (Sichtbarmachung eines Logos, Schriftzuges etc.) durch gesprühte Tropfen.

### Beispiele

### Messbeispiel

### Messung des Wasserkontaktwinkels

### Für Superhydrophobie

Für die Messungen wurde ein "Drop Shape Analyzer DSA100" von der Firma Krüss GmbH, Hamburg, verwendet. Hierbei handelt es sich um ein Kontaktwinkel-Messgerät mit digital bedienbarer Dosiereinheit. Der Prüftropfen wird bei Raumtemperatur mittels einer manuellen Dosiereinheit vorsichtig auf der Probenoberfläche abgelegt und weist ein Volumen von ca. 4 - 6 µl auf. Nach dem Aufbringen des Tropfens wird die Spritze entfernt und eine manuelle Basislinienausrichtung vorgenommen, so dass der Kontaktwinkel zeitnah statisch nach dem Verfahren des ruhenden Tropfens (sessile drop) im Dreiphasen-Kontaktwinkel bestimmt werden kann. Zur Konturanalyse bei großen Kontaktwinkeln wie sie im Rahmen dieser Erfindung anzunehmen sind wird die "Polynomgleichung oder Young-Laplace-Gleichung" verwendet. Diese Messung nimmt das Gerät 10-mal vor und bildet einen Mittelwert des Tropfenrandwinkels.

Um die Oberflächeneigenschaften des Bauteils besser beschreiben zu können, werden zudem an zehn örtlich unterschiedlichen Positionen derselben Probe Messungen mit der Prüfflüssigkeit Wasser vorgenommen. Hieraus wird der Mittelwert gebildet. Bei gekrümmten Oberfläche ist damit zu rechnen, dass diese senkrecht zur Schwerkraft auszurichten sind.

Als Prüfflüssigkeiten wird ausschließlich Wasser (Oberflächenspannung: 72,80 mN/m ; disperser Anteil: 21,80 mN/m ; polarer Anteil: 51,00 mN/m) verwendet. Der Fachmann wird im Zweifel die Oberflächenenergie der Prüfflüssigkeit z.B. mit der Wilhelmy-Waage überprüfen und auch immer auf frische und reine Prüfflüssigkeit achten.

Alternativ kann auch ein anderes Kontaktwinkelmessgerät verwendet werden, solange das sessile drop Verfahren verwendet wird, als auch die übrigen Parameter eingehalten werden.

### Für Superhydrophilie

Zur Bestimmung der superhydrophilen Oberflächeneigenschaft ist eine Messung des Kontaktwinkels nicht möglich bzw. es ist nicht ausreichend, dass kein Kontaktwinkel mehr gemessen werden kann. Als eine alternative Bestimmungsmethode steht der Break-up-Time-Test (BUT) zur Verfügung. Dabei wird die Probe in Wasser eingetaucht, wieder herausgezogen und beobachtet, wie lange sie benetzt bleibt. Die benetzte Zeit sollte ≥ 10 s betragen. Dann gilt Superhydrophilie als gegeben. Als weitere weniger bevorzugte Messmethode kann überprüft werden, ob die Probe nach Anhauchen beschlägt. Dies darf maximal 2-3 s der Fall sein.

### Ausführungsbeispiele

### Geschlossene Kugelbahn (Anfang = Ende)

Die Kugelbahn lässt sich wie ein Stecksystem zusammensetzen, so dass diverse Ausführungen möglich sind. Angaben zur Erzeugung der Mikrostrukturierung lassen sich insbesondere auch aus der Anmeldung mit dem Aktenzeichen DE102018108053.0 entnehmen. Als Grundlage für die Kugelbahn dient eine Bodenplatte ähnlich denen zu Lego oder Duplo, auf der sich ein kleines Becken mit Wasser als Flüssigkeit befindet. Beispielhaft befindet sich darin ein Bauteil in Form einer archimedischen Schraube, mit welchem das Wasser zum höchsten Punkt der Kugelbahn gefördert wird. Durch die Superhydrophobe Ausstattung dieser bilden sich bereits während des Förderns Tropfen. Alternativ hierzu könnte auch ein Tropfenerzeuger zum Einsatz kommen. Die Kugelbahn setzt sich aus Konstruktionsbausteinen für die Erzeugung von Höhenunterschieden sowie den mikrostrukturierten Bauteilen zusammen, welche die Form einer Rinne (Fließbett) besitzen, in der sich die Wassertropfen fortbewegen. Der Verlauf der Bahn beginnt mit einer Gefällestrecke, wodurch die Wassertropfen aufgrund der Schwerkraft an Geschwindigkeit gewinnen. Nach einem kurzen geraden Verlauf schließt sich ein Tropfenteiler in Form eines hydrophobierten Messers an und es ergeben sich zwei parallele Bahnen. Nach einer erneuten Gefällstrecke zur Erzeugung von Geschwindigkeit rollen beide Wassertropfen durch Loopings, welche so ausgerichtet sind, dass die Tropfen sich am Ende wieder vereinen können und durch eine Doppelkurve rollen. Nach einem weiteren kurzen geraden Verlauf treffen die Wassertropfen auf einen Trichter, in welchem sie aus immer kleiner werdenden Runden zur Mitte hin rollen und schlussendlich durch ein Loch fallen. Unter dem Loch befindet sich ein Bauteil mit einem leichten Gefälle, welches zu einer Kurve führt. Daran schließt sich ein rechts-links-geschlängeltes Bauteil an, in welchem der Tropfen aufgrund seiner Geschwindigkeit und den Fliehkräften teilweise an den Wänden hochrollt. Mit einer kleinen Gefällstrecke landen die Wassertropfen danach wieder im Wasserbecken.

### One-Way Kugelbahn

Das Grundprinzip mit Bodenplatte, Konstruktionsbausteinen sowie mikrostrukturierten Bausteinen in Form einer Rinne ist analog zum ersten beschriebenen Beispiel. In diesem Beispiel werden die Tropfen mit einem externen Tropfenerzeuger auf das erste, höchste Bauteil der Kugelbahn gesetzt. Dadurch kann die Höhe der Tropfenabgabe variiert und deren Einfluss auf den weiteren Verlauf des Tropfens beobachtet werden. An den Startstein schließt sich eine Gefällstrecke zur Erzeugung von weiterer Geschwindigkeit an. Anschließend kann mit Hilfe einer Weiche einer von zwei weiteren Wegen gewählt werden. Die Wege unterscheiden sich in der Art und Länge der weiteren verbauten Gefällstrecke, welche sich nach der Weiche anschließt, bevor die Wassertropfen auf eine Sprungschanze treffen. Der Effekt der unterschiedlichen Höhe der Tropfenabgabe auf die Länge des Flugweges kann beobachtet werden.

## Patentansprüche

1. Verwendung eines Bauteils mit wenigstens teilweise gekrümmter Oberfläche (9) mit einer Mikrostrukturierung aus Strukturierungselementen (7) wenigstens im Bereich der Krümmung (9),
wobei der Gegenstand eine Entnahmerichtung (15) besitzt, die sich im Fall von parallel zueinander ausgerichteten Seitenflächen der Mikrostrukturierungselemente (11 und 13) durch die zu diesen Seitenelementen parallele Richtung definiert und sofern die Seitenelemente (11 und 13) der Mikrostrukturierungselemente nicht parallel zueinander ausgerichtet sind, durch diejenige Richtung bestimmt, mit der es mit geringstem Kraftaufwand möglich ist, den Gegenstand mit Mikrostrukturierung aus einer Form zu entnehmen, in der dieser Gegenstand geformt wurde,
wobei
(i) die Strukturierungselemente (7) unabhängig von der Krümmung parallel zu einander ausgerichtet sind,
(ii) die Strukturierungselemente jeweils eine von der Oberfläche des Gegenstandes (1) weg gerichtete zu den anderen Mikrostrukturierungselementen gleichgroße Fläche (5) besitzen und
(iii) die jeweilige Entfernung (3) zwischen den jeweils benachbarten Seitenflächen (11, 13) der Strukturierungselemente (7) gleich ist,
- wenn diese Strukturierungselemente (7) gemeinsam auf einer der Ebenen liegen, in der auch die Entnahmerichtung (15) liegt, und
- die Entfernung (3) auf einer Geraden gemessen wird, die jeweils parallel zur Tangente (8) verläuft, die an dem Streckenmittelpunkt (6) zwischen den jeweiligen Strukturierungselementen (7) anliegt und wobei die Tangente (8) und
- die dazu parallele laufende Gerade, auf der gemessen wird, so gelegt werden, dass die kürzest mögliche Strecke (3) entsteht, die beide benachbarte Strukturierungselemente berührt und
- im von der Oberfläche des Gegenstandes (1) entferntesten Punkt wenigstens einer der Seitenflächen (11) und (13) endet,
als Fließbett für diskrete Mengen einer Flüssigkeit bevorzugt einer Flüssigkeit mit einer Oberflächenspannung ≥ 60 mN/m, bevorzugt ≥ 68 mN/m wobei die diskreten Mengen der Flüssigkeit sich auf der Mikrostrukturierung fortbewegen.

2. Verwendung nach Anspruch 1, wobei die diskreten Mengen der Flüssigkeit ein Volumen ≤ 10 mL, bevorzugt ≤ 1 mL, weiter bevorzugt ≤ 0,5 mL aufweisen.

3. Verwendung nach Anspruch 1 oder 2, wobei die Flüssigkeit zu ≥ 70 Vol-%, bevorzugt zu ≥ 85 Vol-% aus Wasser besteht.

4. Verwendung nach einem der vorangehenden Ansprüche, wobei das Bauteil Teil eines Stecksystems ist.

5. Verwendung nach einem der vorangehenden Ansprüche, wobei der Gegenstand im Bereich der Mikrostrukturierung über einen statischen Wasserrandwinkel gemessen nach DIN 55660 von ≥ 130 °, bevorzugt ≥ 150 ° verfügt.

6. Verwendung nach einem der vorangehenden Ansprüche, wobei ein Mittel zur Verbesserung der optischen Wahrnehmbarkeit der diskreten Mengen der Flüssigkeit eingesetzt wird.

7. Verwendung nach einem der vorangehenden Ansprüche, wobei die von der Oberfläche des Gegenstandes (1) weg gerichteten Flächen (5) der Strukturierungselemente (7) parallel zu der gekrümmten Oberfläche (9) des Bauteils (1) ausgerichtet sind.

8. Verwendung nach einem der vorangehenden Ansprüche in einem Wasserspielzeug oder Anschauungsobjekt.

9. Verwendung nach Anspruch 8, wobei das Wasserspielzeug oder das Anschauungsobjekt ausgewählt sind aus der Gruppe bestehend aus Wasserkugelbahn, Geschicklichkeitsspiel, Suchspiel, Wettbewerbsspiel, Lernspiel, Geduldspiel, Steckspiel, Flipper, Labyrinth, Anordnung für physikalische oder technische Experimente, Nachbildung technischer Einrichtungen und Nachbildung von biologischen Elementen.

10. Verwendung nach Anspruch 8 oder 9, wobei das Wasserspielzeug oder das Anschauungsobjekt eine Vorrichtung für das Fließbett der Flüssigkeit enthält, ausgewählt aus der Gruppe bestehend aus Sprungschanze, Looping, Kurve, Steilkurve, Weiche, Tropfenteiler, Tropfenkollisionszone, Tropfentransportmechanismus, Tropfenkreisel, Trichter und Behälter.

11. Verwendung nach einem der Ansprüche 6 oder 8 bis 10, wobei ein Mittel zur Verbesserung der optischen Wahrnehmbarkeit der diskreten Mengen der Flüssigkeit eingesetzt wird, ausgewählt aus der Gruppe bestehend aus Farbstoff, Konverterpartikeln für UV Licht in sichtbares Licht, Fluoreszenzmittel, Phosphoreszenzmittel, UV-Lichtquelle und Beleuchtungseinheit.

12. Verwendung nach einem der Ansprüche 8 bis 11, wobei das Wasserspielzeug oder das Anschauungsobjekt eines oder mehrere weitere Funktionselemente umfasst, ausgewählt aus der Gruppe bestehend aus Tropfenzähler, Tropfenerzeuger, Tropfenbeschleuniger, Flüssigkeitshebevorrichtung, Geschwindigkeitsmessvorrichtung, Kippvorrichtung, Weichenbetätigungsvorrichtung und Fließbettsperrvorrichtung.

## Claims

1. Use of a component having an at least partially curved surface (9) with a microstructuring composed of structuring elements (7) at least in the region of the curvature (9),
wherein the article has a removal direction (15) which, in the case of side faces of the microstructuring elements (11 and 13) that are oriented parallel to one another, is defined by the direction parallel to these side elements, and if the side elements (11 and 13) of the microstructuring elements are not oriented parallel to one another, is determined by the direction in which it is possible to remove the article with microstructuring with a minimum expenditure of force from a mould in which this article has been moulded,
wherein
(i) the structuring elements (7) are oriented parallel to one another independently of the curvature,
(ii) the structuring elements each have a face (5) which faces away from the surface of the article (1) and which is of equal size to the other microstructuring elements, and
(iii) the respective distance (3) between the respectively adjacent side faces (11, 13) of the structuring elements (7) is the same,
- when these structuring elements (7) lie jointly in one of the planes in which the removal direction (15) also lies and
- the distance (3) is measured on a straight line which in each case runs parallel to the tangent (8) which lies on the distance centre point (6) between the respective structuring elements (7), and wherein the tangent (8) and
- the straight line which runs parallel thereto and on which the measurement is performed are situated in such a way as to produce the shortest possible distance (3) which touches the two adjacent structuring elements and
- which ends at that point on at least one of the side faces (11) and (13) which is furthest away from the article (1),
as fluidized bed for discrete amounts of a liquid, preferably of a liquid having a surface tension ≥ 60 mN/m, preferably ≥ 68 mN/m, wherein the discrete amounts of the liquid move on the microstructuring.

2. Use according to Claim 1, wherein the discrete amounts of the liquid have a volume ≤ 10 mL, preferably ≤ 1 mL, further preferably ≤ 0.5 mL.

3. Use according to Claim 1 or 2, wherein the liquid consists of water to ≥ 70% by volume, preferably to ≥ 85% by volume.

4. Use according to one of the preceding claims, wherein the component is part of a plug-in system.

5. Use according to one of the preceding claims, wherein, in the region of the microstructuring, the article has a static water contact angle of ≥ 130°, preferably ≥ 150°, measured according to DIN 55660.

6. Use according to one of the preceding claims, wherein a means for improving the optical perceptibility of the discrete quantities of the liquid is used.

7. Use according to one of the preceding claims, wherein those faces (5) of the structuring elements (7) which face away from the surface of the article (1) are oriented parallel to the curved surface (9) of the component (1).

8. Use according to one of the preceding claims in a water toy or viewing object.

9. Use according to Claim 8, wherein the water toy or the viewing object are selected from the group consisting of water ball track, game of skill, hidden object game, competitive game, educational game, puzzle, stacking game, pinball, labyrinth, arrangement for physical or technical experiments, simulation of technical devices and simulation of biological elements.

10. Use according to Claim 8 or 9, wherein the water toy or the viewing object contains an apparatus for the fluidized bed of the liquid, selected from the group consisting of ski jump, looping, curve, steep curve, switch, droplet splitter, droplet collision zone, droplet transport mechanism, droplet gyroscope, funnel and container.

11. Use according to one of Claims 6 or 8 to 10, wherein a means for improving the optical perceptibility of the discrete quantities of the liquid is used, selected from the group consisting of colouring agent, converter particles for converting UV light into visible light, fluorescent agent, phosphorescent agent, UV light source and illumination unit.

12. Use according to one of Claims 8 to 11, wherein the water toy or the viewing object comprises one or more further functional elements, selected from the group consisting of droplet counter, droplet generator, droplet accelerator, liquid lifting apparatus, speed measuring apparatus, tilting apparatus, switch actuating apparatus and fluidized-bed locking apparatus.

## Revendications

1. Utilisation d'un composant avec une surface (9) incurvée au moins en partie avec une micro-structuration composée d'éléments de structuration (7) au moins dans la zone de l'incurvation (9),
dans laquelle l'objet possède une direction de retrait (15), qui se définit dans le cas de surfaces latérales, orientées de manière parallèle les unes par rapport aux autres, des éléments de micro-structuration (11 et 13) par la direction parallèle par rapport auxdits éléments latéraux et qui se définit, dans la mesure où les éléments latéraux (11 et 13) des éléments de micro-structuration ne sont pas orientés de manière parallèle les uns par rapport aux autres, par cette direction, avec laquelle précisément il est possible avec un effort de force minimal de retirer l'objet avec la micro-structuration d'un moule, dans lequel ledit objet a été moulé,
dans lequel
(i) les éléments de structuration (7) sont orientés de manière parallèle les uns par rapport aux autres indépendamment de l'incurvation,
(ii) les éléments de structuration possèdent respectivement une surface (5) de même taille par rapport aux autres éléments de micro-structuration dirigée de manière à s'éloigner de la surface de l'objet (1), et
(iii) l'éloignement (3) respectif entre les surfaces latérales (11, 13) respectivement adjacentes des éléments de structuration (7) est identique,
- lorsque ces éléments de structuration (7) se situent conjointement sur un des plans, dans lequel se trouve également la direction de retrait (15), et
- l'éloignement (3) est mesuré sur une droite, qui s'étend respectivement de manière parallèle à la tangente (8), qui repose sur le point central de trajet (6) entre les éléments de structuration (7) respectifs et dans lequel la tangente (8) et
- la droite s'étendant de manière parallèle par rapport à celle-ci, sur laquelle la mesure est réalisée, sont placées de manière à former le trajet (3) le plus court possible qui atteint les deux éléments de structuration adjacents et
- qui se termine dans le point, le plus éloigné de la surface de l'objet (1), d'au moins une des surfaces latérales (11) et (13),
en tant que lit fluidisé pour des quantités discrètes d'un liquide, de manière préférée d'un liquide avec une tension superficielle ≥ 60 mN/m, de manière préférée ≥ 68 mN/m, dans laquelle les quantités discrètes du liquide se déplacent sur la micro-structuration.

2. Utilisation selon la revendication 1, dans laquelle les quantités discrètes du liquide présentent un volume ≤ 10 mL, de manière préférée ≤ 1 mL, de manière davantage préférée ≤ 0,5 mL.

3. Utilisation selon la revendication 1 ou 2, dans laquelle le liquide est constitué à ≥ 70 % en vol., de manière préférée à plus de ≥ 85 % en vol. d'eau.

4. Utilisation selon l'une quelconque des revendications précédentes, dans laquelle le composant fait partie d'un système d'étirage.

5. Utilisation selon l'une quelconque des revendications précédentes, dans laquelle l'objet dispose dans la zone de la micro-structuration d'un angle de contact avec l'eau statique mesuré selon la norme DIN 55660 ≥ 130°, de manière préférée ≥ 150°.

6. Utilisation selon l'une quelconque des revendications précédentes, dans laquelle un moyen est employé pour améliorer la perceptibilité optique des quantités discrètes du liquide.

7. Utilisation selon l'une quelconque des revendications précédentes, dans laquelle les surfaces (5), dirigées de manière à s'éloigner de la surface de l'objet (1), des éléments de structuration (7) sont orientées de manière parallèle par rapport à la surface incurvée (9) du composant (1).

8. Utilisation selon l'une quelconque des revendications précédentes dans un jeu aquatique ou un objet d'observation.

9. Utilisation selon la revendication 8, dans laquelle le jeu aquatique ou l'objet d'observation sont choisis parmi le groupe constitué d'un circuit de billes à eau, un jeu d'adresse, un jeu de piste, un jeu de compétition, un jeu éducatif, un jeu de patience, un jeu de construction, un flipper, un labyrinthe, un ensemble d'expérimentations physiques ou techniques, une reproduction d'équipements techniques et une reproduction d'éléments biologiques.

10. Utilisation selon la revendication 8 ou 9, dans laquelle le jeu aquatique ou l'objet d'observation contient un dispositif pour le lit fluidisé du liquide, choisi parmi le groupe constitué d'un tremplin, un looping, un virage, un virage raide, un aiguillage, un séparateur de gouttes, une zone de collision de gouttes, un mécanisme de transport de gouttes, un rond-point de gouttes, un entonnoir et un récipient.

11. Utilisation selon l'une quelconque des revendications 6 ou 8 à 10, dans laquelle un moyen est employé pour améliorer la perceptibilité optique des quantités discrètes du liquide, choisi parmi le groupe constitué d'un colorant, de particules de matériau convertisseur de lumière UV dans le domaine visible, un produit fluorescent, un produit phosphorescent, une source de lumière UV et une unité d'éclairage.

12. Utilisation selon l'une quelconque des revendications 8 à 11, dans laquelle le jeu aquatique ou l'objet d'observation comprend un ou plusieurs autres éléments fonctionnels choisis parmi le groupe constitué d'un compte-gouttes, un producteur de gouttes, un accélérateur de gouttes, un dispositif de levage de liquide, un dispositif de mesure de vitesse, un dispositif de basculement, un dispositif d'actionnement d'aiguillage et un dispositif de blocage de lit fluidisé.
